# EUROPEAN PATENT APPLICATION

(11) **EP 4 654 176 A1**
(43) Date of publication of application: **26.11.2025**
(21) Application number: 24829871.3
(22) Date of filing: 26.02.2024
(51) Int. Cl.: G09F 9/30

(54) **ELECTRONIC DEVICE**

(30) Priority: 26.06.2023 CN 202310765266
(71) Applicant: Honor Device Co., Ltd., Shenzhen, Guangdong 518040 (CN)
(72) Inventor: GE, Linfeng, Shenzhen, Guangdong 518040 (CN); LI, Haifei, Shenzhen, Guangdong 518040 (CN); GAO, Mingqian, Shenzhen, Guangdong 518040 (CN); WEI, Yameng, Shenzhen, Guangdong 518040 (CN)
(74) Representative: Gill Jennings & Every LLP
(86) International application number: PCT/CN2024/078600
(87) International publication number: WO 2025/001214

(57) **Abstract**

Embodiments of this application provide an electronic device. The electronic device includes a flexible display and a rotating shaft apparatus. The rotating shaft apparatus is disposed on a backlight side of the flexible display. The rotating shaft apparatus includes a shaft base, a swing arm assembly, a door plate assembly, a metal support sheet, and an isolation pad. The swing arm assembly includes a first swing arm and a second swing arm. The first swing arm and the second swing arm are disposed on two sides of the shaft base. Both the first swing arm and the second swing arm are rotatably connected to the shaft base. The door plate assembly includes a first door plate connected to the first swing arm and a second door plate connected to the second swing arm. The metal support sheet is disposed between the door plate assembly and the flexible display. A connection end of the metal support sheet is connected to the first door plate. A free end of the metal support sheet is located on one side that is of the second door plate and that faces the flexible display. The free end is in a free state relative to the second door plate. The isolation pad is connected to the metal support sheet. In a length direction of the shaft base, the isolation pad covers at least a part of the free end. The isolation pad isolates the second door plate from the free end.

## Description

This application claims priority to Chinese Patent Application No. 202310765266.4, filed with the China National Intellectual Property Administration on June 26, 2023 and entitled "ELECTRONIC DEVICE", which is incorporated herein by reference in its entirety.

### TECHNICAL FIELD

Embodiments of this application relate to the field of terminal technologies, and in particular, to an electronic device.

### BACKGROUND

With explosive growth of electronic devices such as smartphones or tablet computers, the electronic devices have more functions. Areas of displays of the electronic devices are different, so that related functions of the electronic devices offer different use experience. Display areas of the displays of the electronic devices are increasingly large. However, when an area of a display is large, an overall size of the electronic device is large, and the electronic device is not easy to carry. With development of display technologies, a flexible display module may be processed and manufactured. The flexible display module includes a flexible display. Compared with a conventional screen, the flexible display has a significant advantage. For example, the flexible display is bendable and flexible. The flexible display can be used in a foldable electronic device. The foldable electronic device includes housings and a rotating shaft apparatus. Two housings may rotate relative to each other around the rotating shaft apparatus to be unfolded or folded. The flexible display is covered on the two housings. When the two housings are unfolded to a same plane, the flexible display is in an unfolded state, and has a large display area. When the two housings are folded with each other, the flexible display is in a folded state, and a volume of the electronic device is small. However, in a folding or unfolding process of the foldable electronic device, parts inside the electronic device may collide or rub against each other to cause an abnormal sound. This affects use experience of the electronic device.

### SUMMARY

Embodiments of this application provide an electronic device, to reduce a possibility of an abnormal sound caused in a folding or unfolding process of the electronic device.

According to a first aspect of this application, an electronic device is provided. The electronic device includes a flexible display and a rotating shaft apparatus.

The rotating shaft apparatus is disposed on a backlight side of the flexible display. The rotating shaft apparatus includes a shaft base, a swing arm assembly, a door plate assembly, a metal support sheet, and an isolation pad. The swing arm assembly includes a first swing arm and a second swing arm. In a width direction of the shaft base, the first swing arm and the second swing arm are respectively disposed on two sides of the shaft base. Both the first swing arm and the second swing arm are rotatably connected to the shaft base. The door plate assembly includes a first door plate and a second door plate. The first door plate is connected to the first swing arm. The second door plate is connected to the second swing arm. The metal support sheet is disposed between the door plate assembly and the flexible display. The metal support sheet includes a connection end and a free end that are opposite to each other. The connection end is connected to the first door plate. The free end is located on one side that is of the second door plate and that faces the flexible display, and the free end is in a free state relative to the second door plate. The isolation pad is connected to the metal support sheet. In a length direction of the shaft base, the isolation pad covers at least a part of the free end. The isolation pad isolates the second door plate from the free end.

In the electronic device in this embodiment of this application, the metal support sheet may isolate the flexible display from a structural member in the rotating shaft apparatus, for example, isolate the flexible display from the shaft base, the swing arm assembly, and the door plate assembly of the rotating shaft apparatus, to reduce a possibility of structural damage to the flexible display caused by impact from the structural member of the rotating shaft apparatus in a folding or unfolding process. The metal support sheet may be folded or unfolded along with the door plate assembly. The isolation pad is disposed on the metal support sheet. In a folding or unfolding process of the metal support sheet, the isolation pad moves along with the metal support sheet. The isolation pad may cover at least the part of the free end, so that the isolation pad isolates the free end from the second door plate, and the free end is not likely to be in contact with the second door plate. Therefore, in the folding or unfolding process of the metal support sheet, the free end is not likely to scratch a structural member of the second door plate. This reduces a possibility of an abnormal sound caused by direct scratch between the free end and the structural member of the second door plate. In addition, in a manner of disposing the isolation pad on the metal support sheet, difficulty of a process for implementing mutual combination between the isolation pad and the metal support sheet is low. This helps reduce costs.

In a possible implementation, in the length direction of the shaft base, the isolation pad covers the entire free end.

The isolation pad may fully cover the free end, so that isolation effect can be further improved. This helps reduce a possibility of contact scratch between any position of the free end and the second door plate.

In a possible implementation, the rotating shaft apparatus further includes a shielding sheet. In the length direction of the shaft base, two ends of the isolation pad are connected to the shielding sheet. The shielding sheet covers the free end.

The isolation pad and the shielding sheet may jointly cover the free end, to further reduce an exposed area of the free end. This helps further reduce a possibility of scratch between the free end and an external structural member.

In a possible implementation, the isolation pad includes a first connection section, a bent connection section, and a second connection section. The first connection section is disposed on one side that is of the metal support sheet and that faces the flexible display. The second connection section is disposed on one side that is of the metal support sheet and that faces the second door plate. The bent connection section connects the first connection section and the second connection section. The first connection section, the bent connection section, and the second connection section are enclosed to form accommodation space. The free end is inserted into the accommodation space.

A structure of the isolation pad is simple, so that processing difficulty of the isolation pad is reduced, and processing costs are reduced.

In a possible implementation, there are more than two second connection sections. In the length direction of the shaft base, the more than two second connection sections are spaced.

A manner of disposing the second connection sections in this embodiment helps save usage of the isolation pad and reduce production costs.

In a possible implementation, there are more than two bent connection sections. The bent connection sections and the second connection sections are disposed in a one-to-one correspondence.

A manner of correspondingly disposing the bent connection sections and the second connection sections further helps save usage of the isolation pad and reduce production costs.

In a possible implementation, there are more than two first connection sections. The first connection sections and the bent connection sections are disposed in a one-to-one correspondence.

A manner of disposing the first connection sections helps further save usage of the isolation pad and reduce production costs.

In a possible implementation, in the width direction of the shaft base, a width of the first connection section is greater than a width of the second connection section.

In a possible implementation, in the width direction of the shaft base, a width of the first connection section is less than a width of the second connection section.

In a possible implementation, in the width direction of the shaft base, a width of the first connection section is greater than a width of the second connection section. The first connection section covers an entire surface that is of the metal support sheet and that faces the flexible display.

The first connection section may isolate the metal support sheet from the flexible display, so that the first connection section may protect the flexible display. This helps reduce a possibility that the metal support sheet directly scratches the flexible display.

In a possible implementation, one part of the second connection section is located between the second door plate and the metal support sheet, and the other part of the second connection section is located between the metal support sheet and the swing arm assembly and between the metal support sheet and the shaft base.

The second connection section may isolate the metal support sheet from the swing arm assembly, so that a possibility that the metal support sheet is in contact with the swing arm assembly to cause scratch and an abnormal sound between the metal support sheet and the swing arm assembly can be reduced. In addition, the second connection section may isolate the metal support sheet from the shaft base, so that a possibility that the metal support sheet is in contact with the shaft base to cause scratch and an abnormal sound between the metal support sheet and the shaft base can be reduced.

In a possible implementation, the isolation pad is a flexible pad.

In a case in which the isolation pad and the second door plate slide relative to each other, the isolation pad may provide effective buffering, to reduce a possibility of an abnormal sound between the isolation pad and the second door plate and also reduce a possibility that the isolation pad is in contact with and scratches the second door plate to cause a scratch on the second door plate. The first connection section located between the metal support sheet and the flexible display may have a buffering function, so that the flexible display may be in flexible contact with the first connection section. This helps further reduce a possibility of structural damage to the flexible display.

In a possible implementation, the isolation pad is an insulation pad.

A part that is of the isolation pad and that is located between the flexible display and the metal support sheet (for example, the first connection section) may have an insulation and isolation function, to reduce a possibility that an electrical signal is transmitted between the flexible display and the metal support sheet through the metal support sheet.

In a possible implementation, the free end includes an upper surface facing the flexible display, a lower surface facing the second door plate, and a transition connection surface. The transition connection surface connects the upper surface and the lower surface. The lower surface is a curved surface. In a direction away from the connection end, a thickness of the free end decreases.

In a process in which the free end moves relative to the second door plate, the free end is not likely to squeeze a part of the isolation pad, so that a possibility that stress concentration is generated on the isolation pad to cause a crack or damage to the isolation pad is reduced.

In a possible implementation, the transition connection surface is a curved surface. The lower surface, the transition connection surface, and the upper surface are of smooth transition, so that there is no sharp edge on the free end. This reduces a possibility that the free end has a sharp edge, and the sharp edge squeezes a part of the isolation pad to cause damage to the isolation pad, and further reduces a possibility that the isolation pad is damaged to cause the isolation pad to fail to isolate and cause the free end to directly scratch the second door plate.

In a possible implementation, the connection end is bonded to the first door plate.

The connection end and the first door plate are bonded, so that a connection component such as a screw, a buckle, or a rivet does not need to be additionally disposed between the connection end and the first door plate. Therefore, this helps reduce complexity of a connection structure between the connection end and the first door plate and reduce assembly difficulty. In addition, a corresponding connection structure, such as a hole, does not need to be provided on the connection end and the first door plate. This helps reduce processing difficulty of the connection end and the first door plate and improve structural integrity of the connection end and the first door plate.

In a possible implementation, the isolation pad is bonded to the metal support sheet.

The isolation pad and the metal support sheet are bonded, so that a connection component such as a screw, a buckle, or a rivet does not need to be disposed between the isolation pad and the metal support sheet. Therefore, this helps reduce complexity of a connection structure between the isolation pad and the metal support sheet and reduce assembly difficulty. In addition, a corresponding connection structure, such as a hole, does not need to be provided on the isolation pad and the metal support sheet. This helps reduce processing difficulty of the isolation pad and the metal support sheet and improve structural integrity of the isolation pad and the metal support sheet.

According to a second aspect of this application, an electronic device is provided. The electronic device includes a flexible display and a rotating shaft apparatus.

The rotating shaft apparatus is disposed on a backlight side of the flexible display. The rotating shaft apparatus includes a shaft base, a swing arm assembly, a door plate assembly, and a metal support sheet. The swing arm assembly includes a first swing arm and a second swing arm. In a width direction of the shaft base, the first swing arm and the second swing arm are respectively disposed on two sides of the shaft base. Both the first swing arm and the second swing arm are rotatably connected to the shaft base. The door plate assembly includes a first door plate and a second door plate. The first door plate is connected to the first swing arm. The second door plate is connected to the second swing arm. The metal support sheet is disposed between the door plate assembly and the flexible display. The metal support sheet includes a connection end and a free end that are opposite to each other. The connection end is connected to the first door plate. The free end is located on one side that is of the second door plate and that faces the flexible display, and the free end is in a free state relative to the second door plate. The free end includes an upper surface facing the flexible display, a lower surface facing the second door plate, and a transition connection surface. The transition connection surface connects the upper surface and the lower surface. The lower surface is a curved surface. In a direction away from the connection end, a thickness of the free end decreases.

In this embodiment, the free end of the metal support sheet may be in direct contact with the second door plate. No isolation structure is disposed between the free end and the second door plate. In a folding or unfolding process of the second door plate, the free end slides relative to the second door plate, so that friction resistance is generated between the free end and the second door plate. Because the lower surface of the free end is the curved surface that is of smooth transition, when a relative movement occurs between the free end and the second door plate, the free end is not likely to squeeze a part of the second door plate, so that a relative movement process between the free end and the second door plate is smooth and gentle, and therefore, in the relative movement process between the free end and the second door plate, an abnormal sound is not likely to be generated due to friction between the free end and the second door plate. This helps improve a degree of silence in a switching process of the electronic device between an unfolded state and a folded state and improve use experience, and also helps reduce a possibility that the second door plate is scratched by the free end to cause a scratch. In addition, processing difficulty of the free end in this embodiment is low, and an isolation structure does not need to be disposed on the second door plate. This helps reduce costs.

In a possible implementation, the transition connection surface is a curved surface, and the lower surface, the transition connection surface, and the upper surface are of smooth transition.

### BRIEF DESCRIPTION OF DRAWINGS

FIG. 1 is a diagram of a structure of an electronic device according to an embodiment of this application;
FIG. 2 is a diagram of a structure of an electronic device in a semi-folded state according to an embodiment of this application;
FIG. 3 is a diagram of a structure of an electronic device in a folded state according to an embodiment of this application;
FIG. 4 is a diagram of a partially exploded structure of an electronic device according to an embodiment of this application;
FIG. 5 is a diagram of a partial cross-sectional structure of an electronic device in an unfolded state in a related technology;
FIG. 6 is a diagram of a partial structure of a metal support sheet in a related technology;
FIG. 7 is a diagram of a partial cross-sectional structure of an electronic device in a folded state in a related technology;
FIG. 8 is a diagram of a partial cross-sectional structure of an electronic device in an unfolded state according to an embodiment of this application;
FIG. 9 is a diagram of a partial cross-sectional structure of an electronic device in a folded state according to an embodiment of this application;
FIG. 10 is a diagram of a partial structure of a metal support sheet and an isolation pad in a bent state according to an embodiment of this application;
FIG. 11 is a diagram of a partial structure of a metal support sheet and an isolation pad in a bent state according to another embodiment of this application;
FIG. 12 is an enlarged diagram of a position W in FIG. 11;
FIG. 13 is a diagram of a partial structure of a metal support sheet and an isolation pad in a bent state according to still another embodiment of this application;
FIG. 14 is a diagram of a partial structure of a metal support sheet and an isolation pad in a connected state according to an embodiment of this application;
FIG. 15 is a diagram of a partial structure of a metal support sheet and an isolation pad in a bent state according to still another embodiment of this application;
FIG. 16 is a diagram of a partial structure of a metal support sheet and an isolation pad in a bent state according to still another embodiment of this application;
FIG. 17 is a diagram of a partial structure of a metal support sheet and an isolation pad in a bent state according to yet another embodiment of this application;
FIG. 18 is a diagram of a partial structure of a metal support sheet and an isolation pad in an unfolded state according to an embodiment of this application;
FIG. 19 is a diagram of a partial cross-sectional structure of an electronic device in a folded state according to an embodiment of this application;
FIG. 20 is a diagram of a partial structure of a metal support sheet and an isolation pad in a connected state according to another embodiment of this application;
FIG. 21 is a diagram of a partial cross-sectional structure of an electronic device in an unfolded state according to another embodiment of this application;
FIG. 22 is a diagram of a partial cross-sectional structure of an electronic device in a folded state according to another embodiment of this application;
FIG. 23 is a diagram of a partial structure of a metal support sheet according to another embodiment of this application; and
FIG. 24 is an enlarged diagram of a position P in FIG. 23.

Reference numerals:
10: electronic device;
20: housing;
30: frame;
40: rotating shaft apparatus;
   41: shaft base;
   42: swing arm assembly; 421: first swing arm; 422: second swing arm;
   43: door plate assembly; 431: first door plate; 432: second door plate;
   44: metal support sheet; 441: connection end; 442: free end; 442a: upper surface; 442b: lower surface; 442c: transition connection surface;
   45: isolation pad; 451: first connection section; 452: second connection section; 453: bent connection section;
   46: shielding sheet;
50: flexible display; 51: first display region; 52: second display region; 53: third display region;
X: length direction;
Y: width direction.

### DESCRIPTION OF EMBODIMENTS

An electronic device in embodiments of this application may be referred to as a user equipment (user equipment, UE), a terminal (terminal), or the like. For example, the electronic device may be a mobile terminal such as a tablet computer (portable android device, PAD), a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home), or a fixed terminal. A form of the terminal device is not specifically limited in embodiments of this application.

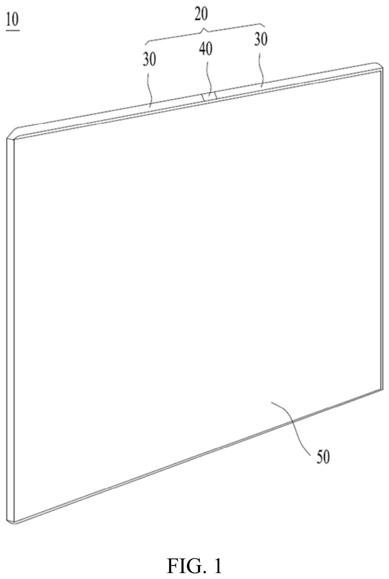

In an embodiment of this application, FIG. 1 schematically shows a structure of an electronic device 10. As shown in FIG. 1, an example in which the electronic device 10 is a handheld device with a wireless communication function is used for description. The handheld device with a wireless communication function may be, for example, a foldable electronic device 10. The electronic device 10 may be a foldable mobile phone that includes a foldable flexible display.

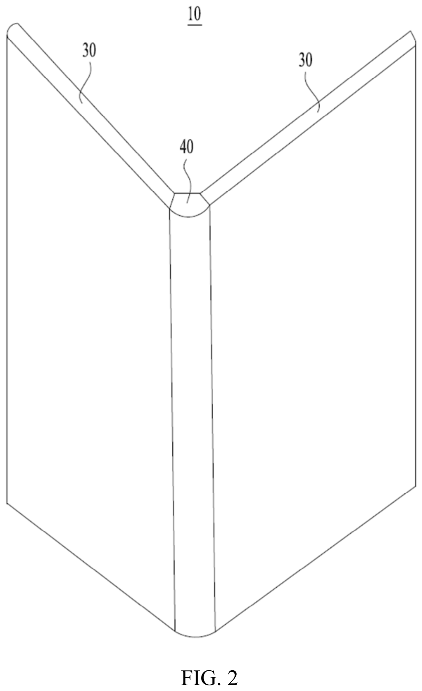

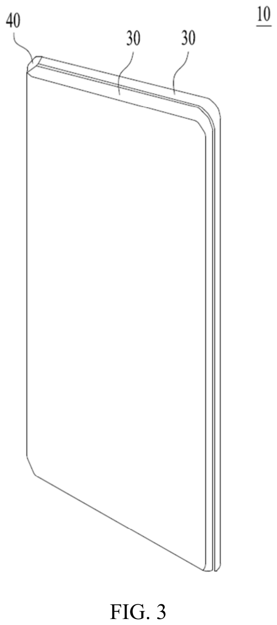

FIG. 2 schematically shows a structure of the electronic device 10 in a semi-folded state. FIG. 3 schematically shows a structure of the electronic device 10 in a folded state. As shown in FIG. 1 to FIG. 3, the electronic device 10 includes a housing 20. An example in which the housing 20 at least includes two frames 30 and a rotating shaft apparatus 40 is used for description. The two frames 30 are respectively located on two sides of the rotating shaft apparatus 40. The two frames 30 are rotatably connected to the rotating shaft apparatus 40 separately. For example, the two frames 30 may be separately connected to the rotating shaft apparatus 40 in a soldering manner, a fastener locking manner, or the like. The two frames 30 may be rotated and folded separately. When the two frames 30 are close to each other and are stacked with each other, the electronic device 10 is in the folded state. When the two frames 30 move away from each other from a stacked state, and the two frames 30 rotate to a state in which the two frames 30 cannot rotate, the electronic device 10 is in an unfolded state. A process in which the two frames 30 change from the folded state to the unfolded state is an unfolding process, and a process in which the frames 30 change from the unfolded state to the folded state is a folding process. For example, when the electronic device 10 is in the folded state, the two frames 30 are stacked to present a state of a two-layer structure. For example, the frame 30 may include a middle frame or a back cover. The frame 30 may be connected to the rotating shaft apparatus 40 by using a middle frame.

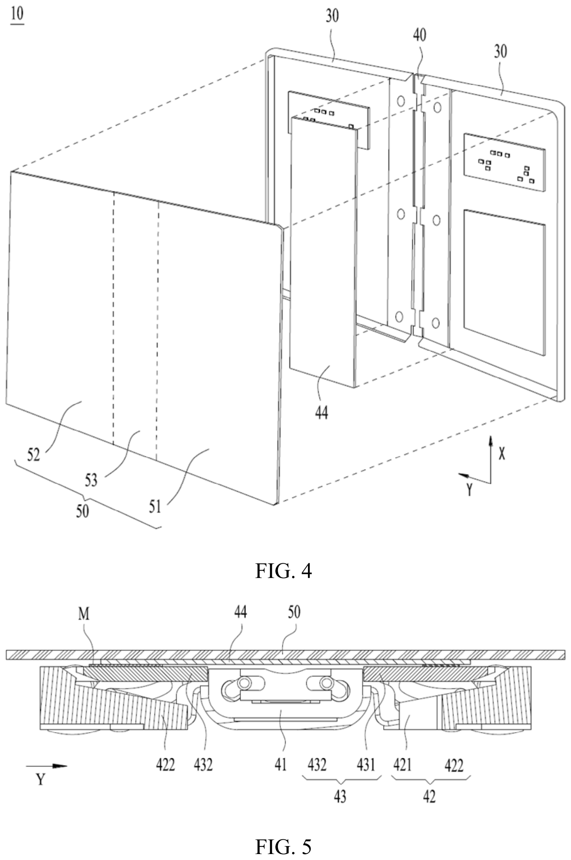

FIG. 4 schematically shows a partially exploded structure of the electronic device 10. As shown in FIG. 1 and FIG. 4, the electronic device 10 further includes a flexible display 50. The flexible display 50 is covered on the housing 20. The rotating shaft apparatus 40 is disposed on a backlight side of the flexible display 50. The housing 20 may provide a mounting base for the flexible display 50. The flexible display 50 includes a display portion configured to display image information. One side that is of the flexible display 50 and that is configured to display the image information is a light-emitting side. The backlight side and the light-emitting side are disposed opposite to each other. The flexible display 50 may have a touch function. The user may touch a display region of the flexible display 50 by using a hand to execute a corresponding operation instruction.

The flexible display 50 is bendable and may be folded under an external force. When the electronic device 10 is in the unfolded state, the display portion of the flexible display 50 is unfolded to present the image information to the user. The display portion may include a first display region 51, a second display region 52, and a third display region 53. The first display region 51 and the second display region 52 are respectively disposed corresponding to the two frames 30. The third display region 53 may be disposed corresponding to the rotating shaft apparatus 40.

When the two frames 30 are in the folded state, the display portion is in a bent state. The first display region 51 and the second display region 52 of the display portion may be stacked with each other, and the third display region 53 may bend into an arc state. For example, the third display region 53 may bend into a droplet state.

When the two frames 30 are in the unfolded state, the display portion is in the unfolded state, and the first display region 51, the second display region 52, and the third display region 53 present a flat state. An overall size of the electronic device 10 may be changed through folding or unfolding, and there may be a large display area in the unfolded state.

A printed circuit board (printed circuit board, PCB) and an electronic component may be respectively disposed in the two frames 30 of the electronic device 10. The electronic component is disposed on the printed circuit board. For example, the electronic component may include but is not limited to a processor, a memory, or a camera module. A printed circuit board in one frame 30 may be used as a main board.

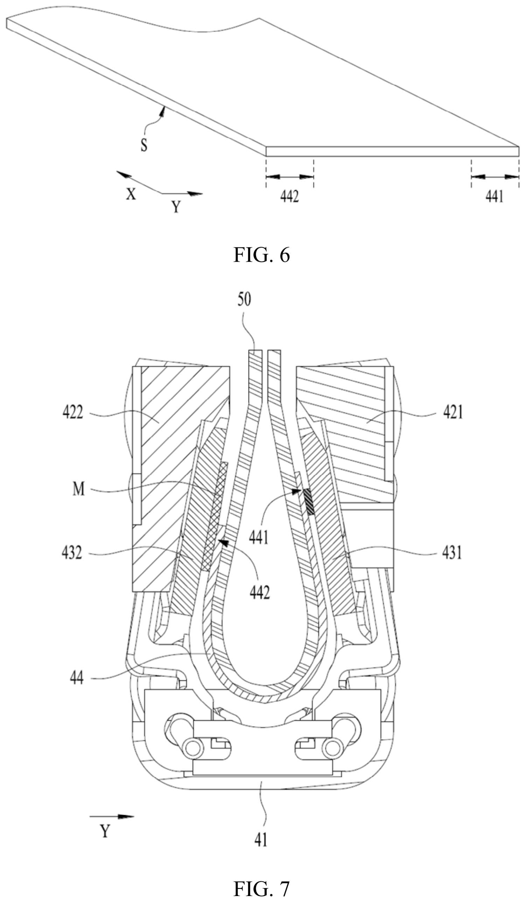

In a related technology, FIG. 5 schematically shows a partial cross-sectional structure of an electronic device 10 in an unfolded state in the related technology. FIG. 6 schematically shows a partial structure of a metal support sheet in the related technology. FIG. 7 schematically shows a partial cross-sectional structure of the electronic device 10 in a folded state in the related technology. As shown in FIG. 5 to FIG. 7, because structural strength of a flexible display 50 is low, there is a possibility of structural damage to the flexible display 50 caused by partial impact from an external structural member. Therefore, a metal support sheet 44 is disposed between a rotating shaft apparatus 40 and the flexible display 50. The metal support sheet 44 may isolate the rotating shaft apparatus 40 from the flexible display 50, so that the metal support sheet 44 has a buffering function between the rotating shaft apparatus 40 from the flexible display 50, to effectively improve impact resistance performance at the flexible display 50 and help reduce a possibility of structural damage to the flexible display 50 caused by partial impact from a structural member in the rotating shaft apparatus 40 to the flexible display 50. One end of the metal support sheet 44 is connected to a door plate in the rotating shaft apparatus 40, and the other end is a free end 442 in a free state. The free end 442 has a sharp edge S. In folding and unfolding processes of the electronic device 10, the rotating shaft apparatus 40 may drive the metal support sheet 44 to bend or unfold. In a bending or unfolding process of the metal support sheet 44, the free end 442 of the metal support sheet 44 slides relative to a corresponding door plate, so that the sharp edge S of the free end 442 is likely to scratch a structural member on a sliding path to cause an abnormal sound. To improve a problem of the abnormal sound caused in a folding or unfolding process, a protection patch M is disposed on the door plate that is in the rotating shaft apparatus 40 and that corresponds to the free end 442. The protection patch M is fastened the door plate, so that a relative position between the protection patch M and the door plate does not change. Although the protection patch M may help reduce scratch between the free end 442 of the metal support sheet 44 and another structural member in a sliding process, the protection patch M needs to be disposed above all structural members that are on a door plate and that may be scratched by the free end 442. Because a structure of the door plate is complex, and a quantity of structural components is large, difficulty of a process for disposing the protection patch M on the door plate is high, and costs are high.

According to the electronic device 10 provided in this embodiment of this application, an isolation pad is disposed on the metal support sheet 44. The isolation pad and the free end 442 of the metal support sheet 44 move synchronously. The isolation pad may isolate the metal support sheet 44 from the corresponding door plate. In the folding and unfolding processes of the electronic device 10, the metal support sheet 44 is not likely to scratch another structural member to cause an abnormal sound, and difficulty of a combination process of the isolation pad and the metal support sheet 44 is low. This helps reduce costs.

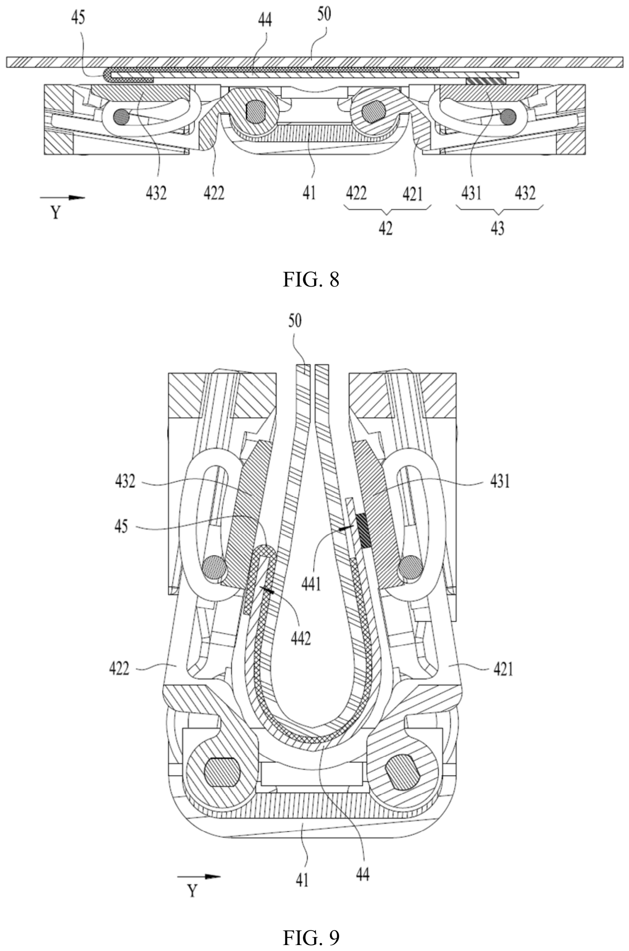

FIG. 8 schematically shows a partial cross-sectional structure of the electronic device 10 in the unfolded state. FIG. 9 schematically shows a partial cross-sectional structure of the electronic device 10 in the folded state. As shown in FIG. 8 and FIG. 9, the electronic device 10 in this embodiment of this application includes the rotating shaft apparatus 40. The rotating shaft apparatus 40 includes a shaft base 41, a swing arm assembly 42, a door plate assembly 43, a metal support sheet 44, and an isolation pad 45.

The shaft base 41 may shield another structural member on the rotating shaft apparatus 40, so that an appearance of the electronic device 10 is neat and beautiful. When the two frames 30 rotate relative to the rotating shaft apparatus 40, a position of the shaft base 41 may remain relatively fastened. The shaft base 41 may provide a mounting base for a related structural member in the rotating shaft apparatus 40. The shaft base 41 may be strip-shaped structure. In some examples, when the two frames 30 are in the unfolded state, the two frames 30 may shield the shaft base 41, so that the shaft base 41 is in an invisible state. When the two frames 30 are in the folded state, at least a part of the shaft base 41 may be exposed out of the two frames 30 to be in a visible state.

The swing arm assembly 42 includes a first swing arm 421 and a second swing arm 422. In a width direction Y of the shaft base 41, the first swing arm 421 and the second swing arm 422 are respectively disposed on two sides of the shaft base 41. Both the first swing arm 421 and the second swing arm 422 are rotatably connected to the shaft base 41. The first swing arm 421 and the second swing arm 422 may be respectively connected to one frame 30. In a folding or unfolding process of the two frames 30, the two frames 30 may respectively drive the corresponding first swing arm 421 and second swing arm 422 to rotate relative to the shaft base 41, so that the first swing arm 421 and the second swing arm 422 switch between a folded position and an unfolded position.

The door plate assembly 43 includes a first door plate 431 and a second door plate 432. In the width direction Y of the shaft base 41, the first door plate 431 and the second door plate 432 are respectively disposed on two sides of the shaft base 41. The first door plate 431 and the second door plate 432 are located below the flexible display 50. The first door plate 431 is connected to the first swing arm 421. The second door plate 432 is connected to the second swing arm 422. When the first swing arm 421 and the second swing arm 422 rotate relative to the shaft base 41, the first door plate 431 and the second door plate 432 rotate relative to the shaft base 41 along with the first swing arm 421 and the second swing arm 422 respectively, so that the first door plate 431 and the second door plate 432 may be switched between a folded position and an unfolded position. When the flexible display 50 is folded, the first door plate 431 and the second door plate 432 may provide support for the flexible display 50, to guide the flexible display 50 to bend into an expected bent form. For example, the first door plate 431 and the second door plate 432 are disposed corresponding to the third display region 53 of the flexible display 50, so that the third display region 53 of the flexible display 50 is likely to bend into the droplet shape.

The metal support sheet 44 is disposed between the door plate assembly 43 and the flexible display 50. The metal support sheet 44 and the flexible display 50 are in a non-connected state. The metal support sheet 44 includes a connection end 441 and a free end 442. In the width direction Y of the shaft base 41, the connection end 441 and the free end 442 are disposed opposite to each other. The connection end 441 of the metal support sheet 44 is connected to the first door plate 431. The free end 442 of the metal support sheet 44 is located on one side that is of the second door plate 432 and that faces the flexible display 50, and the free end 442 is in a free state relative to the second door plate 432. In a folding process of the first door plate 431 and the second door plate 432, the metal support sheet 44 is folded under action of the first door plate 431 and the second door plate 432. A shape of the folded metal support sheet 44 may match a shape of the third display region 53. The metal support sheet 44 may provide support for the folded third display region 53. The metal support sheet 44 may be elastic. In an unfolding process of the first door plate 431 and the second door plate 432, the metal support sheet 44 is unfolded under an elastic recovery force of the metal support sheet 44. The metal support sheet 44 in the unfolded state may support the third display region 53, to reduce a possibility of collapse and deformation of the third display region 53. In a folding or unfolding process of the metal support sheet 44, a relative position between the connection end 441 of the metal support sheet 44 and the first door plate 431 does not change, and the free end 442 of the metal support sheet 44 is in the free state, so that the free end 442 of the metal support sheet 44 moves relative to the second door plate 432, and a relative position between the free end 442 and the second door plate 432 may change. In the folding or unfolding process of the metal support sheet 44, the metal support sheet 44 may move relative to the flexible display 50.

For example, a material of the metal support sheet 44 may be but is not limited to stainless steel or titanium alloy. A shape of the metal support sheet 44 in the unfolded state may be but is not limited to a rectangle. A length direction of the metal support sheet 44 is the same as a length direction X of the shaft base 41.

The isolation pad 45 is connected to the metal support sheet 44. In the length direction X of the shaft base 41, the isolation pad 45 covers at least a part of the free end 442. The isolation pad 45 isolates the second door plate 432 from the free end 442 of the metal support sheet 44, so that the second door plate 432 and the free end 442 of the metal support sheet 44 are in a state in which the second door plate 432 is not in direct contact with the free end 442 of the metal support sheet 44. The isolation pad 45 and a surface that is of the second door plate 432 and that faces the flexible display 50 may be in a contact state. The isolation pad 45 is fastened to the metal support sheet 44, so that a relative position between the isolation pad 45 and the metal support sheet 44 does not change. In a process in which the metal support sheet 44 switches between the folded state and the unfolded state, the isolation pad 45 and the free end 442 of the metal support sheet 44 move synchronously, so that both the isolation pad 45 and the free end 442 of the metal support sheet 44 can move relative to the second door plate 432.

For example, a surface that is of the isolation pad 45 and that faces the second door plate 432 may be a smooth surface, that is, a surface with small surface roughness. For example, a value range of the surface roughness is 0.5 microns (µm) to 1.6 microns. Therefore, in a process in which the isolation pad 45 slides relative to the second door plate 432, this helps reduce friction resistance between the isolation pad 45 and the second door plate 432, and helps improve smoothness of a folding or unfolding process of the electronic device 10 and improve use experience.

In the electronic device 10 in this embodiment of this application, the metal support sheet 44 may isolate the flexible display 50 from a structural member in the rotating shaft apparatus 40, for example, isolate the flexible display 50 from the shaft base 41, the swing arm assembly 42, and the door plate assembly 43 of the rotating shaft apparatus 40, to reduce a possibility of structural damage to the flexible display 50 caused by impact from the structural member of the rotating shaft apparatus 40 in a folding or unfolding process. The metal support sheet 44 may be folded or unfolded along with the door plate assembly 43. The isolation pad 45 is disposed on the metal support sheet 44. In the folding or unfolding process of the metal support sheet 44, the isolation pad 45 moves along with the metal support sheet 44. The isolation pad 45 may cover at least the part of the free end 442, so that the isolation pad 45 isolates the free end 442 from the second door plate 432, and the free end 442 is not likely to be in contact with the second door plate 432. Therefore, in the folding or unfolding process of the metal support sheet 44, the free end 442 is not likely to scratch a structural member of the second door plate 432. This reduces a possibility of an abnormal sound caused by direct scratch between the free end 442 and the structural member of the second door plate 432. In addition, in a manner of disposing the isolation pad 45 on the metal support sheet 44, difficulty of a process for implementing mutual combination between the isolation pad 45 and the metal support sheet 44 is low. This helps reduce costs.

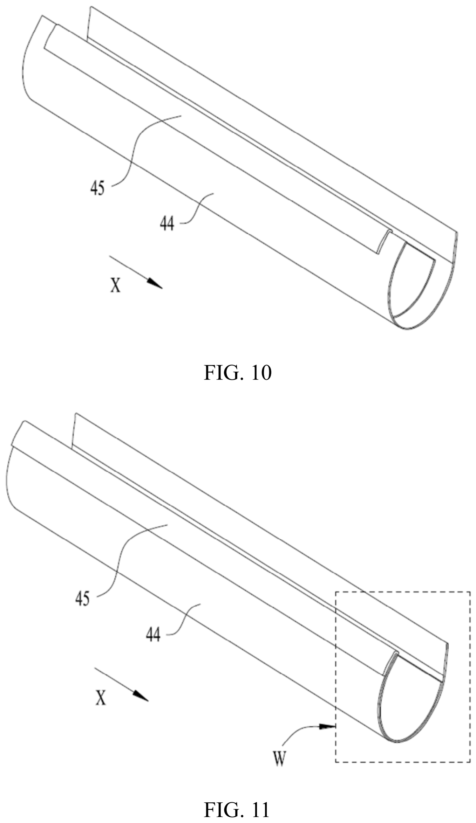

In some implementations, FIG. 10 schematically shows a partial structure of the metal support sheet 44 and the isolation pad 45 in a bent state. As shown in FIG. 10, in the length direction X of the shaft base 41, the isolation pad 45 continuously extends. A length of the isolation pad 45 may be less than a length of the free end 442, so that in the length direction X of the shaft base 41, the isolation pad 45 may cover the part of the free end 442. A shape of the isolation pad 45 in the folded state may be but is not limited to a rectangle. A length direction of the isolation pad 45 is the same as the length direction X of the shaft base 41.

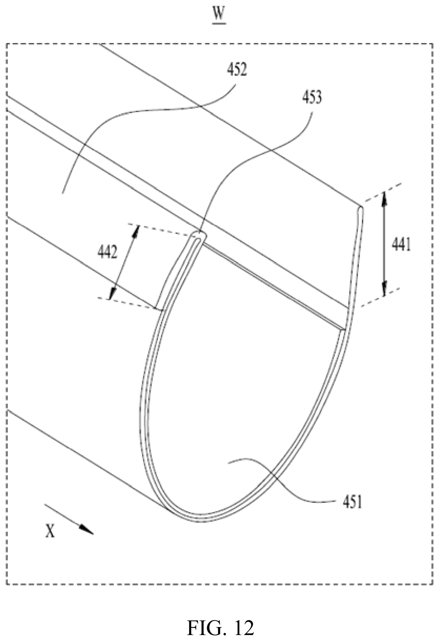

In some implementations, FIG. 11 schematically shows a partial structure of the metal support sheet 44 and the isolation pad 45 in the bent state. FIG. 12 is an enlarged diagram of a position W in FIG. 11. As shown in FIG. 11 and FIG. 12, in the length direction X of the shaft base 41, the isolation pad 45 covers the entire free end 442. The isolation pad 45 continuously extends, and the length of the isolation pad 45 may be equal to the length of the free end 442. Therefore, in the length direction X of the shaft base 41, the isolation pad 45 is disposed between any position of the free end 442 and the second door plate 432. The isolation pad 45 may fully cover the free end 442, so that isolation effect can be further improved. This helps reduce a possibility of contact scratch between any position of the free end 442 and the second door plate 432.

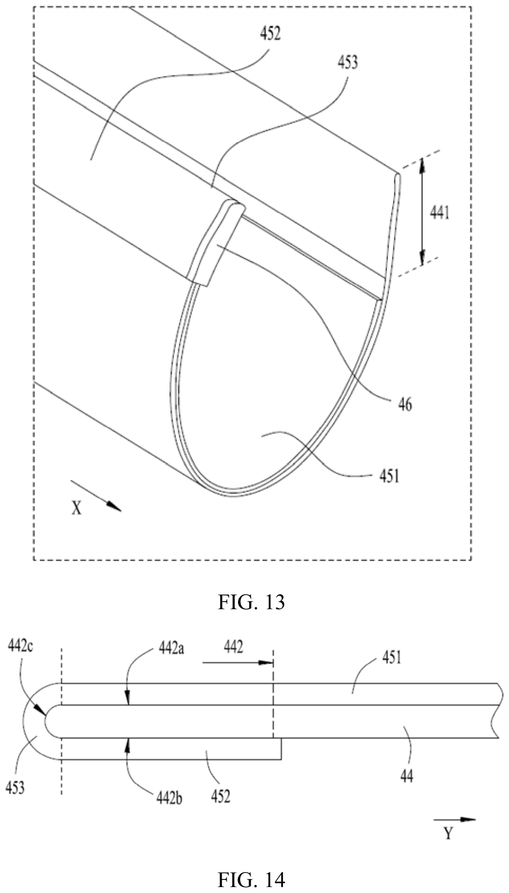

In some examples, FIG. 13 schematically shows a partial structure of the metal support sheet 44 and the isolation pad 45 in the bent state. As shown in FIG. 13, the rotating shaft apparatus 40 further includes a shielding sheet 46. In the length direction X of the shaft base 41, two ends of the isolation pad 45 are connected to the shielding sheet 46. The shielding sheet 46 shields the free end 442 of the metal support sheet 44. For example, in the length direction X of the shaft base 41, the isolation pad 45 fully covers the free end 442. The isolation pad 45 does not cover two end surfaces of the free end 442 in a length direction. The shielding sheet 46 may cover the end surfaces of the free end 442. The isolation pad 45 and the shielding sheet 46 may jointly cover the free end 442, to further reduce an exposed area of the free end 442. This helps further reduce a possibility of scratch between the free end 442 and an external structural member.

For example, a material of the isolation pad 45 may be the same as a material of the shielding sheet 46. The isolation pad 45 and the shielding sheet 46 are of an integrally formed structure.

As shown in FIG. 13, the isolation pad 45 may include a first connection section 451, a second connection section 452, and a bent connection section 453. The first connection section 451 is disposed on one side that is of the metal support sheet 44 and that faces the flexible display 50. For example, the first connection section 451 may be connected to a surface that is of the metal support sheet 44 and that faces the flexible display 50. The second connection section 452 is disposed on one side that is of the metal support sheet 44 and that faces the second door plate 432. For example, the second connection section 452 may be connected to a surface that is of the metal support sheet 44 and that faces the second door plate 432. The bent connection section 453 connects the first connection section 451 and the second connection section 452. The first connection section 451, the bent connection section 453, and the second connection section 452 are enclosed to form accommodation space. The free end 442 of the metal support sheet 44 is inserted into the accommodation space, so that the isolation pad 45 covers the free end 442. A structure of the isolation pad 45 is simple, so that processing difficulty of the isolation pad 45 is reduced, and processing costs are reduced.

In some examples, as shown in FIG. 11 and FIG. 12, in the length direction X of the shaft base 41, all the first connection section 451, the bent connection section 453, and the second connection section 452 continuously extend, that is, there are one first connection section 451, one bent connection section 453, and one second connection section 452. A length of the first connection section 451 is equal to a length of the bent connection section 453. The length of the bent connection section 453 is equal to a length of the second connection section 452. For example, the shape of the isolation pad 45 in the unfolded state may be a rectangle. The length direction of the isolation pad 45 is the same as the length direction X of the shaft base 41.

FIG. 14 schematically shows a partial structure of the metal support sheet 44 and the isolation pad 45 in a connected state. As shown in FIG. 14, the free end 442 includes an upper surface 442a facing the flexible display 50, a lower surface 442b facing the second door plate 432, and a transition connection surface 442c. The transition connection surface 442c connects the upper surface 442a and the lower surface 442b. The upper surface 442a of the free end 442 is disposed facing away from the second door plate 432. The first connection section 451 may cover the upper surface 442a of the free end 442. The second connection section 452 may cover the lower surface 442b of the free end 442. The bent connection section 453 may cover the transition connection surface 442c. For example, the transition connection surface 442c of the free end 442 may be a plane. For example, the transition connection surface 442c of the free end 442 may be a curved surface. The bent connection section 453 is arc-shaped. For example, the transition connection surface 442c may be a circular arc surface, and the bent connection section 453 may be circular-arc-shaped.

In a thickness direction of the metal support sheet 44, a thickness of each of the first connection section 451 and the second connection section 452 may be set to a small size. This helps reduce a space occupancy rate of the isolation pad 45 in the thickness direction of the metal support sheet 44 and reduce a possibility that a lightweight design of the electronic device 10 is affected due to a large thickness of the isolation pad 45.

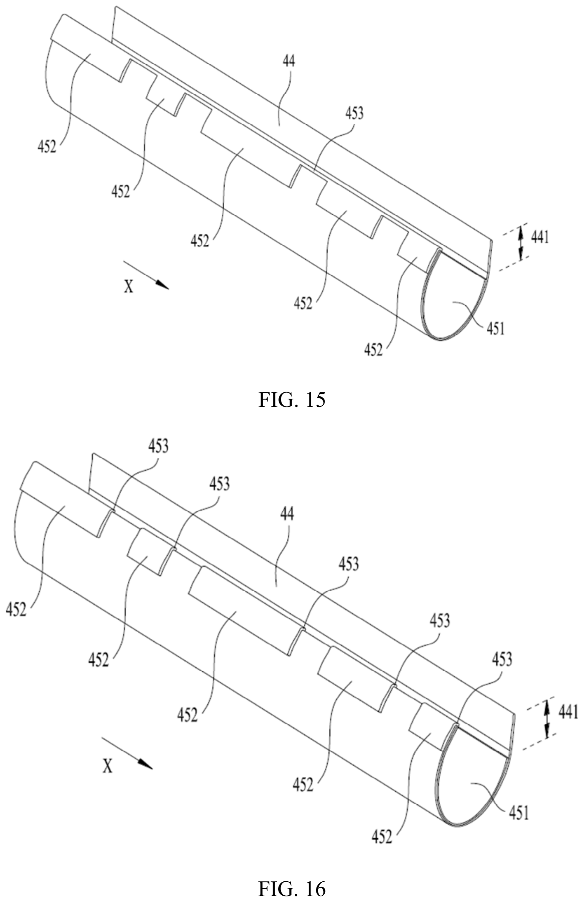

In some examples, FIG. 15 schematically shows a partial structure of the metal support sheet 44 and the isolation pad 45 in the bent state. As shown in FIG. 15, there are more than two second connection sections 452. In the length direction X of the shaft base 41, the more than two second connection sections 452 are spaced. Avoidance space is formed between two adjacent second connection sections 452. A part that is of the free end 442 and that corresponds to the avoidance space is in an exposed state. The second connection section 452 is located between the free end 442 and the second door plate 432. The second connection sections 452 may be correspondingly disposed based on a position of a structural component, on the second door plate 432, that needs to be isolated from the free end 442, and the second connection section 452 may not be disposed in a region, on the second door plate 432, that does not need to be isolated from the free end 442. Therefore, a manner of disposing the second connection sections 452 in this embodiment helps save usage of the isolation pad 45 and reduce production costs. In some examples, in the length direction X of the shaft base 41, both the first connection section 451 and the bent connection section 453 may continuously extend, that is, there are one first connection section 451 and one bent connection section 453.

For example, FIG. 16 schematically shows a partial structure of the metal support sheet 44 and the isolation pad 45 in the bent state. As shown in FIG. 16, there are more than two bent connection sections 453. In the length direction X of the shaft base 41, the more than two bent connection sections 453 are spaced. The bent connection sections 453 and the second connection sections 452 are disposed in a one-to-one correspondence. A quantity of the bent connection sections 453 is equal to a quantity of the second connection sections 452. A manner of correspondingly disposing the bent connection sections 453 and the second connection sections 452 further helps save usage of the isolation pad 45 and reduce production costs. For example, in the length direction X of the shaft base 41, the length of the bent connection section 453 is equal to the length of the second connection section 452. For example, in the length direction X of the shaft base 41, the first connection section 451 may continuously extend, that is, there is one first connection section 451.

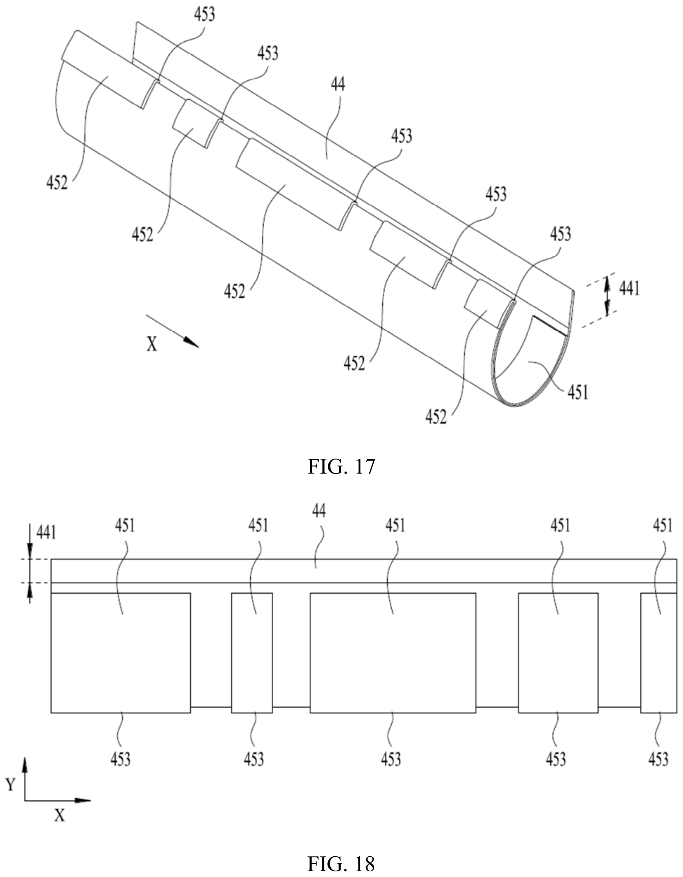

For example, FIG. 17 schematically shows a partial structure of the metal support sheet 44 and the isolation pad 45 in the bent state. FIG. 18 schematically shows a partial structure of the metal support sheet 44 and the isolation pad 45 in the unfolded state. As shown in FIG. 17 and FIG. 18, there are more than two first connection sections 451. In the length direction X of the shaft base 41, the more than two first connection sections 451 are spaced. The first connection sections 451 and the bent connection sections 453 are disposed in a one-to-one correspondence. A quantity of the first connection sections 451 is equal to the quantity of the bent connection sections 453. The quantity of the bent connection sections 453 is equal to the quantity of the second connection sections 452. In the width direction Y of the shaft base 41, one first connection section 451, one bent connection section 453, and one second connection section 452 are connected to each other. A manner of disposing the first connection sections 451 helps further save usage of the isolation pad 45 and reduce production costs.

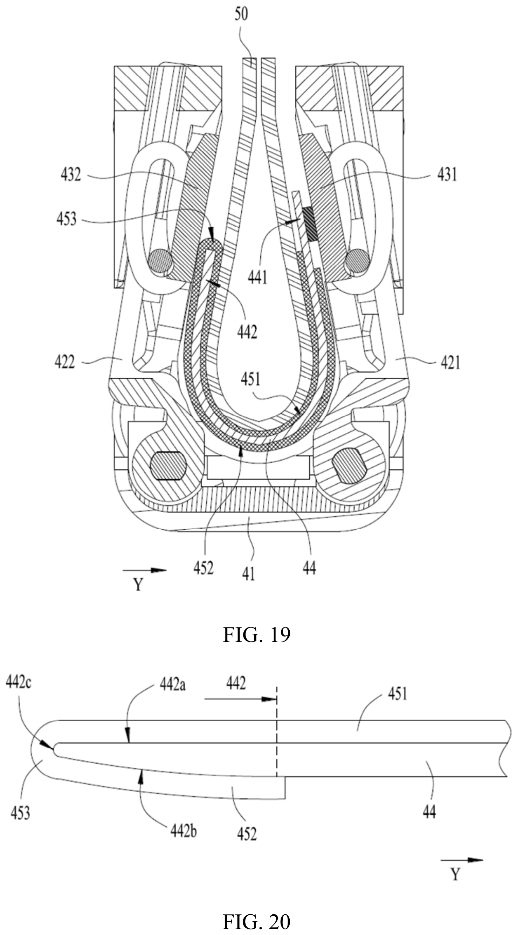

In some example, FIG. 19 schematically shows a partial cross-sectional structure of the electronic device 10 in the folded state. As shown in FIG. 19, the first connection section 451 is disposed on one side that is of the metal support sheet 44 and that faces the flexible display 50. The first connection section 451 may isolate the metal support sheet 44 from the flexible display 50, so that the first connection section 451 may protect the flexible display 50. This helps reduce a possibility that the metal support sheet 44 directly scratches the flexible display 50.

For example, in the width direction Y of the shaft base 41, a width of the first connection section 451 is greater than a width of the second connection section 452. For the metal support sheet 44 in the unfolded state, an area of an orthographic projection of the first connection section 451 on the metal support sheet 44 may be greater than an area of an orthographic projection of the second connection section 452 on the metal support sheet 44. For example, the first connection section 451 may cover a surface of the metal support sheet 44 except connection sections, or the first connection section 451 may cover an entire surface that is of the metal support sheet 44 and that faces the flexible display 50. This helps the first connection section 451 maintain a large area and improves protection performance.

In some examples, the second connection section 452 is disposed on one side that is of the metal support sheet 44 and that faces the second door plate 432. One part of the second connection section 452 may be located between the second door plate 432 and the metal support sheet 44, and the other part of the second connection section 452 may be located between the metal support sheet 44 and the swing arm assembly 42 and between the metal support sheet 44 and the shaft base 41. Therefore, the second connection section 452 may isolate the metal support sheet 44 from the swing arm assembly 42, so that a possibility that the metal support sheet 44 is in contact with the swing arm assembly 42 to cause scratch and an abnormal sound between the metal support sheet 44 and the swing arm assembly 42 can be reduced. In addition, the second connection section 452 may isolate the metal support sheet 44 from the shaft base 41, so that a possibility that the metal support sheet 44 is in contact with the shaft base 41 to cause scratch and an abnormal sound between the metal support sheet 44 and the shaft base 41 can be reduced. The second connection section 452 may cover the surface of the metal support sheet 44 except connection sections, or the second connection section 452 may cover an entire surface that is of the metal support sheet 44 and that faces away from the flexible display 50. This helps the second connection section 452 maintain a large area and improves protection performance.

In some examples, in the width direction Y of the shaft base 41, the width of the first connection section 451 is less than the width of the second connection section 452. For the metal support sheet 44 in the unfolded state, the area of the orthographic projection of the first connection section 451 on the metal support sheet 44 may be less than the area of the orthographic projection of the second connection section 452 on the metal support sheet 44.

In some examples, in the width direction Y of the shaft base 41, the width of the first connection section 451 is equal to the width of the second connection section 452.

In some implementations, the isolation pad 45 is a flexible pad. Stiffness of the isolation pad 45 is less than stiffness of the second door plate 432. In a case in which the isolation pad 45 and the second door plate 432 slide relative to each other, the isolation pad 45 may provide effective buffering, to reduce a possibility of an abnormal sound between the isolation pad 45 and the second door plate 432 and also reduce a possibility that the isolation pad 45 is in contact with and scratches the second door plate 432 to cause a scratch on the second door plate 432. In addition, the isolation pad 45 may be separately processed and manufactured. The isolation pad 45 is bendable. In a process of assembling the isolation pad 45 and the metal support sheet 44, the isolation pad 45 may be likely to be deformed to match the shape of the metal support sheet 44, to reduce a possibility of a gap between the isolation pad 45 and the metal support sheet 44 due to a shape mismatch after the isolation pad 45 and the metal support sheet 44 are assembled. The stiffness of the isolation pad 45 is less than stiffness of the metal support sheet 44. The first connection section 451 located between the metal support sheet 44 and the flexible display 50 may have a buffering function, so that the flexible display 50 may be in flexible contact with the first connection section 451. This helps further reduce a possibility of structural damage to the flexible display 50.

In some implementations, the isolation pad 45 is an insulation pad. The isolation pad 45 has insulation and isolation performance. A part that is of the isolation pad 45 and that is located between the flexible display 50 and the metal support sheet 44 (for example, the first connection section 451) may have an insulation and isolation function, to reduce a possibility that an electrical signal is transmitted between the flexible display 50 and the metal support sheet 44 through the metal support sheet 44. The isolation pad 45 with insulation performance may also have good flexibility. In this way, noise caused by mutual impact or friction between the flexible display 50 and the isolation pad 45 is not likely to be generated between the flexible display 50 and the isolation pad 45. This helps improve a degree of silence in a switching process of the electronic device 10 between the unfolded state and the folded state, and also helps reduce a possibility that the flexible display 50 is scratched by the isolation pad 45 to cause a scratch.

In some examples, the isolation pad 45 may be a plastic film. For example, the material of the isolation pad 45 may include but is not limited to polyethylene terephthalate, polyvinyl chloride, polyethylene, polypropylene, or polystyrene. For example, the isolation pad 45 may be a mylar (mylar) sheet.

In some examples, an insulating material may be sprayed on the metal support sheet 44 by using a surface spraying process, to form the isolation pad 45 with insulation performance.

In some implementations, FIG. 20 schematically shows a partial structure of the metal support sheet 44 and the isolation pad 45 in an assembled state. As shown in FIG. 20, the free end 442 includes the upper surface 442a facing the flexible display 50, the lower surface 442b facing the second door plate 432, and the transition connection surface 442c. The transition connection surface 442c connects the upper surface 442a and the lower surface 442b. The lower surface 442b of the free end 442 is a curved surface. In a direction away from the connection end 441, a thickness of the free end 442 decreases. The isolation pad 45 covers at least a part of the lower surface 442b. In a process in which the free end 442 moves relative to the second door plate 432, the free end 442 is not likely to squeeze a part of the isolation pad 45, so that a possibility that stress concentration is generated on the isolation pad 45 to cause a crack or damage to the isolation pad 45 is reduced. For example, the lower surface 442b of the free end 442 is an arc-shaped surface. For example, the thickness of the isolation pad 45 is uniform.

In some examples, the transition connection surface 442c of the free end 442 is a curved surface. The lower surface 442b, the transition connection surface 442c, and the upper surface 442a are of smooth transition, so that there is no sharp edge on the free end 442. This reduces a possibility that the free end 442 has a sharp edge, and the sharp edge squeezes a part of the isolation pad 45 to cause damage to the isolation pad 45, and further reduces a possibility that the isolation pad 45 is damaged to cause the isolation pad 45 to fail to isolate and cause the free end 442 to directly scratch the second door plate 432. For example, the transition connection surface 442c of the free end 442 is an arc-shaped surface. For example, the transition connection surface 442c is a circular arc surface.

In some examples, for the metal support sheet 44 in the unfolded state, the upper surface 442a of the free end 442 may be a plane.

In some implementations, the connection end 441 of the metal support sheet 44 is bonded to the first door plate 431. A bonding agent is applied to the connection end 441 or the first door plate 431, and then the connection end 441 is bonded to the first door plate 431. The bonding agent may be, for example, an adhesive. The connection end 441 and the first door plate 431 are bonded, so that a connection component such as a screw, a buckle, or a rivet does not need to be additionally disposed between the connection end 441 and the first door plate 431. Therefore, this helps reduce complexity of a connection structure between the connection end 441 and the first door plate 431 and reduce assembly difficulty. In addition, a corresponding connection structure, such as a hole, does not need to be provided on the connection end 441 and the first door plate 431. This helps reduce processing difficulty of the connection end 441 and the first door plate 431 and improve structural integrity of the connection end 441 and the first door plate 431.

In some implementations, the isolation pad 45 is bonded to the metal support sheet 44. The isolation pad 45 may be separately processed and manufactured in advance, and then the isolation pad 45 is fastened to a predetermined position of the metal support sheet 44 in an assembled manner. In an assembly process, the bonding agent may be applied to the isolation pad 45 or the metal support sheet 44, and then the isolation pad 45 is bonded to the metal support sheet 44. The bonding agent may be, for example, an adhesive. The isolation pad 45 and the metal support sheet 44 are bonded, so that a connection component such as a screw, a buckle, or a rivet does not need to be disposed between the isolation pad 45 and the metal support sheet 44. Therefore, this helps reduce complexity of a connection structure between the isolation pad 45 and the metal support sheet 44 and reduce assembly difficulty. In addition, a corresponding connection structure, such as a hole, does not need to be provided on the isolation pad 45 and the metal support sheet 44. This helps reduce processing difficulty of the isolation pad 45 and the metal support sheet 44 and improve structural integrity of the isolation pad 45 and the metal support sheet 44.

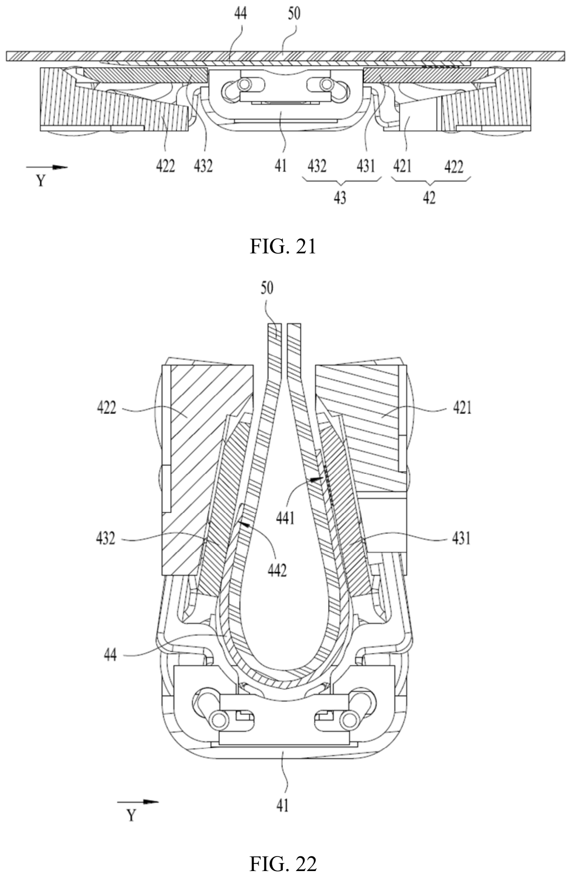

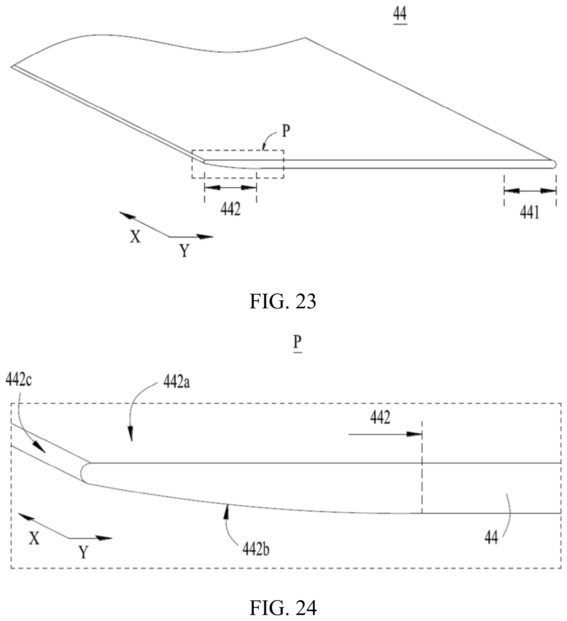

FIG. 21 schematically shows a partial cross-sectional structure of an electronic device 10 in an unfolded state. FIG. 22 schematically shows a partial cross-sectional structure of the electronic device 10 in a folded state. FIG. 23 schematically shows a partial structure of a metal support sheet 44. FIG. 24 is an enlarged diagram of a position P in FIG. 23. As shown in FIG. 21 and FIG. 24, an embodiment of this application further provides an electronic device 10. For structures in the electronic device 10 in this embodiment that are the same as those in the foregoing electronic device 10, details are not described herein again. The electronic device 10 includes a flexible display 50 a rotating shaft apparatus 40. The metal support sheet 44 is disposed between a door plate assembly 43 and the flexible display 50. The metal support sheet 44 includes a connection end 441 and a free end 442 that are opposite to each other. The connection end 441 is connected to a first door plate 431. The free end 442 is located on one side that is of a second door plate 432 and that faces the flexible display 50, and the free end 442 is in a free state relative to the second door plate 432. The free end 442 includes an upper surface 442a facing the flexible display 50, a lower surface 442b facing the second door plate 432, and a transition connection surface 442c. The transition connection surface 442c connects the upper surface 442a and the lower surface 442b. The lower surface 442b of the free end 442 is a curved surface. In a direction away from the connection end 441, a thickness of the free end 442 decreases.

In this embodiment, the free end 442 of the metal support sheet 44 may be in direct contact with the second door plate 432. No isolation structure is disposed between the free end 442 and the second door plate 432. In a folding or unfolding process of the second door plate 432, the free end 442 slides relative to the second door plate 432, so that friction resistance is generated between the free end 442 and the second door plate 432. Because the lower surface 442b of the free end 442 is the curved surface that is of smooth transition, when a relative movement occurs between the free end 442 and the second door plate 432, the free end 442 is not likely to squeeze a part of the second door plate 432, so that a relative movement process between the free end 442 and the second door plate 432 is smooth and gentle, and therefore, in the relative movement process between the free end 442 and the second door plate 432, an abnormal sound is not likely to be generated due to scratch between the free end 442 and the second door plate 432. This helps improve a degree of silence in a switching process of the electronic device 10 between the unfolded state and the folded state and improve use experience, and also helps reduce a possibility that the second door plate 432 is scratched by the free end 442 to cause a scratch. In addition, processing difficulty of the free end 442 in this embodiment is low, and an isolation structure does not need to be disposed on the second door plate 432. This helps reduce costs.

In some implementations, the transition connection surface 442c of the free end 442 is a curved surface. The lower surface 442b, the transition connection surface 442c, and the upper surface 442a are of smooth transition, so that there is no sharp edge on the free end 442. This helps further reduce a possibility of an abnormal sound caused by scratch generated in a relative movement process between the free end 442 and the second door plate 432. This helps further reduce a possibility that the second door plate 432 is scratched by the free end 442 to cause a scratch. In addition, this helps reduce a possibility that the free end 442 scratches or cuts the flexible display 50 in folding and unfolding processes of the metal support sheet 44. For example, the lower surface 442b of the free end 442 may be an arc-shaped surface. The transition connection surface 442c of the free end 442 is an arc-shaped surface. For example, the transition connection surface 442c is a circular arc surface. For example, for the metal support sheet 44 in the unfolded state, the upper surface 442a of the free end 442 may be a plane.

In descriptions of embodiments of this application, it should be noted that, unless otherwise explicitly specified and defined, the terms "mounting", "connection to", and "connection" should be understood in a broad sense, for example, may be a fixed connection, an indirect connection through an intermediate medium, or an internal connection between two elements or an interactive relationship between two elements. For a person of ordinary skill in the art, specific meanings of the foregoing terms in embodiments of this application may be understood based on a specific situation.

In embodiments of this application, the terms do not indicate or imply that the indicated apparatus or element needs to have a specific orientation or needs to be constructed and operated in a specific orientation. Therefore, the terms should not be construed as a limitation on embodiments of this application. In the descriptions of embodiments of this application, unless otherwise exactly and specifically specified, "a plurality of" means two or more.

In the specification, claims, and accompanying drawings of this application, terms "first", "second", "third", "fourth", and the like (if existent) are intended to distinguish between similar objects but do not necessarily indicate a specific order or sequence. It should be understood that data used in such a way is interchangeable in a proper situation, so that embodiments of this application described herein can be implemented in other orders than the order illustrated or described herein. In addition, the terms "include", "have", and any other variants thereof are intended to cover a non-exclusive inclusion. For example, a process, method, system, product, or device that includes a list of steps or units is not necessarily limited to those steps or units that are clearly listed, but may include other steps or units that are not clearly listed or are inherent to the process, method, system, product, or device.

The term "a plurality of" in this specification means two or more. The term "and/or" in this specification describes only an association relationship for describing associated objects and indicates that three relationships may exist. For example, A and/or B may indicate the following three cases: Only A exists, both A and B exist, and only B exists. In addition, the character "/" in this specification generally indicates an "or" relationship between the associated objects; and in formulas, the character "/" indicates a "division" relationship between the associated objects.

It may be understood that various numbers in embodiments of this application are merely used for differentiation for ease of description, and are not used to limit the scope of embodiments of this application.

It should be understood that sequence numbers of the foregoing processes do not mean execution sequences in embodiments of this application. The execution sequences of the processes should be determined based on functions and internal logic of the processes, and should not be construed as any limitation on the implementation processes of embodiments of this application.

## Claims

1. An electronic device, comprising:
a flexible display; and
a rotating shaft apparatus, disposed on a backlight side of the flexible display, wherein the rotating shaft apparatus comprises:
a shaft base;
a swing arm assembly, comprising a first swing arm and a second swing arm, wherein in a width direction of the shaft base, the first swing arm and the second swing arm are respectively disposed on two sides of the shaft base, and both the first swing arm and the second swing arm are rotatably connected to the shaft base;
a door plate assembly, comprising a first door plate and a second door plate, wherein the first door plate is connected to the first swing arm, and the second door plate is connected to the second swing arm;
a metal support sheet, disposed between the door plate assembly and the flexible display, wherein the metal support sheet comprises a connection end and a free end that are opposite to each other, the connection end is connected to the first door plate, the free end is located on one side that is of the second door plate and that faces the flexible display, and the free end is in a free state relative to the second door plate; and
an isolation pad, connected to the metal support sheet, wherein in a length direction of the shaft base, the isolation pad covers at least a part of the free end, and the isolation pad isolates the second door plate from the free end.

2. The electronic device according to claim 1, wherein in the length direction of the shaft base, the isolation pad covers the entire free end.

3. The electronic device according to claim 2, wherein the rotating shaft apparatus further comprises a shielding sheet, in the length direction of the shaft base, two ends of the isolation pad are connected to the shielding sheet, and the shielding sheet shields the free end.

4. The electronic device according to claim 1, wherein the isolation pad comprises a first connection section, a bent connection section, and a second connection section, the first connection section is disposed on one side that is of the metal support sheet and that faces the flexible display, the second connection section is disposed on one side that is of the metal support sheet and that faces the second door plate, the bent connection section connects the first connection section and the second connection section, the first connection section, the bent connection section, and the second connection section are enclosed to form accommodation space, and the free end is inserted into the accommodation space.

5. The electronic device according to claim 4, wherein there are more than two second connection sections, and in the length direction of the shaft base, the more than two second connection sections are spaced.

6. The electronic device according to claim 5, wherein there are more than two bent connection sections, and the bent connection sections and the second connection sections are disposed in a one-to-one correspondence.

7. The electronic device according to claim 6, wherein there are more than two first connection sections, and the first connection sections and the bent connection sections are disposed in a one-to-one correspondence.

8. The electronic device according to any one of claims 4 to 7, wherein in the width direction of the shaft base, a width of the first connection section is greater than a width of the second connection section, or in the width direction of the shaft base, a width of the first connection section is less than a width of the second connection section.

9. The electronic device according to any one of claims 4 to 7, wherein in the width direction of the shaft base, a width of the first connection section is greater than a width of the second connection section, and the first connection section covers an entire surface that is of the metal support sheet and that faces the flexible display.

10. The electronic device according to any one of claims 4 to 7, wherein one part of the second connection section is located between the second door plate and the metal support sheet, and the other part of the second connection section is located between the metal support sheet and the swing arm assembly and between the metal support sheet and the shaft base.

11. The electronic device according to any one of claims 1 to 10, wherein the isolation pad is a flexible pad.

12. The electronic device according to any one of claims 1 to 11, wherein the isolation pad is an insulation pad.

13. The electronic device according to any one of claims 1 to 12, wherein the free end comprises an upper surface facing the flexible display, a lower surface facing the second door plate, and a transition connection surface, the transition connection surface connects the upper surface and the lower surface, the lower surface is a curved surface, and in a direction away from the connection end, a thickness of the free end decreases.

14. The electronic device according to claim 13, wherein the transition connection surface is a curved surface, and the lower surface, the transition connection surface, and the upper surface are of smooth transition.

15. The electronic device according to any one of claims 1 to 14, wherein the connection end is bonded to the first door plate.

16. The electronic device according to any one of claims 1 to 15, wherein the isolation pad is bonded to the metal support sheet.

17. An electronic device, comprising:
a flexible display; and
a rotating shaft apparatus, disposed on a backlight side of the flexible display, wherein the rotating shaft apparatus comprises:
a shaft base;
a swing arm assembly, comprising a first swing arm and a second swing arm, wherein in a width direction of the shaft base, the first swing arm and the second swing arm are respectively disposed on two sides of the shaft base, and both the first swing arm and the second swing arm are rotatably connected to the shaft base;
a door plate assembly, comprising a first door plate and a second door plate, wherein the first door plate is connected to the first swing arm, and the second door plate is connected to the second swing arm; and
a metal support sheet, disposed between the door plate assembly and the flexible display, wherein the metal support sheet comprises a connection end and a free end that are opposite to each other, the connection end is connected to the first door plate, the free end is located on one side that is of the second door plate and that faces the flexible display, the free end is in a free state relative to the second door plate, the free end comprises an upper surface facing the flexible display, a lower surface facing the second door plate, and a transition connection surface, the transition connection surface connects the upper surface and the lower surface, the lower surface is a curved surface, and in a direction away from the connection end, a thickness of the free end decreases.

18. The electronic device according to claim 17, wherein the transition connection surface is a curved surface, and the lower surface, the transition connection surface, and the upper surface are of smooth transition.
